# EUROPEAN PATENT SPECIFICATION

(11) **EP 0 610 643 B1**
(45) Date of publication and mention of the grant of the patent: **10.09.1997**
(21) Application number: 93830050.6
(22) Date of filing: 11.02.1993
(51) Int. Cl.: H01L 21/82, H01L 29/788, H01L 27/115

(54) **EEPROM cell and peripheral MOS transistor**
EEPROM-Zelle und peripherer MOS-Transistor
Cellule EEPROM et transistor MOS périphérique

(43) Date of publication of application: 17.08.1994
(73) Proprietor: SGS-THOMSON MICROELECTRONICS s.r.l., 20041 Agrate Brianza (Milano) (IT)
(72) Inventor: Cappelletti, Paolo Giuseppe, I-20030 Seveso (IT); Cantarelli, Daniele, I-20058 Villasanta (IT)
(74) Representative: Cerbaro, Elena

(56) References cited:
- EP-A- 0 106 617
- EP-A- 0 244 367
- EP-A- 0 305 741
- DE-A- 3 107 543
- GB-A- 2 167 602

## Description

The present invention relates to a process for fabricating integrated devices including flash-EEPROM memories and transistors.

Flash-EEPROM memories are Electrically Erasable Programmable Read Only Memories (EEPROMs) which combine the high density and low cost of EPROMs with the advantage of electrical erasability, and have recently become the most attractive of nonvolatile memories for their potential application in solid state disks for portable computers.

Although different flash memory concepts have been developed, most flash manufacturers utilize the double-poly single-transistor cell which is very similar to a standard EPROM cell.

Fig.s 1 and 2 show cross sections of EPROM and flash-EEPROM cells respectively.

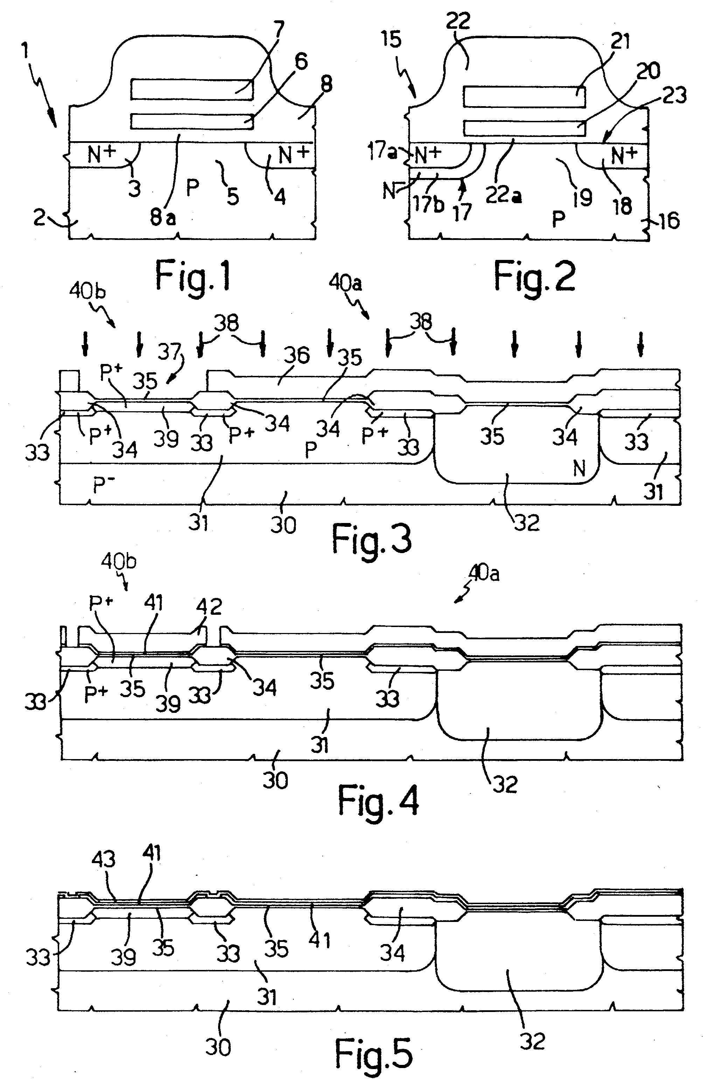

As shown in Fig.1, an EPROM cell, indicated as a whole by 1, is formed in a substrate 2, in this case a P type, housing N+ type source and drain regions 3 and 4 separated by a channel region 5 formed by the substrate itself. Over substrate 2, at channel 5, two gate regions are provided: a floating gate region 6 completely embedded in an oxide layer 8, and a control gate region 7. Gate region 6 is made of polycrystalline silicon; gate region 7 may be polysilicon or silicide (polysilicon and silicide); and the floating gate region is separated from the substrate by an oxide layer (gate oxide) 8a of a given thickness (typically 200 Å).

As shown in Fig.2, a flash-EEPROM cell, indicated as a whole by 15, is very similar to the Fig.1 EPROM cell, and is formed in a P type substrate 16 housing source and drain regions 17 and 18 separated by channel 19. In this case also, provision is made for a floating gate region 20 and a control gate region 21, both surrounded by an oxide layer 22. As compared with EPROM cell 1, however, the oxide layer 22a separating floating gate region 20 from substrate 16 and known as the tunnel oxide is much thinner, typically 100-130 Å. In the specific embodiment shown, source region 16 presents a graded junction with the substrate, and more specifically is formed in two parts: a heavily doped (N+) part 16a facing the larger surface 23 of the substrate, and a deeper, lightly doped (N-) part 16b surrounding part 16a on the sides not facing surface 23.

The purpose of a graded junction is to enable the cell to better withstand the electrical stress to which it is subjected during erasing and programming, and may or may not be provided, depending on the operating conditions of the memory array. The thin tunnel oxide layer, on the other hand, is essential for enabling electronic erasing (and programming) of the cell by Fowler-Nordheim tunneling between the substrate and floating gate.

Flash-EEPROM fabrication involves specific steps for forming the tunnel oxide layer, due to its limited thickness, thus ruling out direct application of standard EPROM processes.

The present applicant has developed and patented an EPROM process whereby the second polysilicon layer is deposited directly on the first in the circuit transistor area, for forming the gate regions of the transistors (and which thus, unlike other known processes, does not require removal of the first polysilicon layer in the circuit area). This process, protected by Patent US-A-4.719.184 issued on 12.1.88 and known as DPCC (Shorted Double Poly) provides for advantages in terms of reliability and the number of masks required.

It is an object of the present invention to provide a process for fabricating integrated devices, designed to exploit the basic principle and so achieve the technical advantages of the known DPCC process.

According to the present invention, there is provided a process of fabricating flash-EEPROM nonvolatile memory cells and circuit transistors, as claimed in Claim 1.

A preferred, non-limiting embodiment of the present invention will be described by way of example with reference to the accompanying drawings, in which:
Fig.1 shows a cross section of a known EPROM cell;
Fig.2 shows a cross section, as in Fig.1, of a known flash-EEPROM cell;
Fig.s 3-9 show cross sections of a silicon wafer relative to various steps in the known DPCC process for fabricating an integrated device including an EPROM memory and transistors;
Fig.s 10-13 show cross sections of a silicon wafer relative to various steps in the fabrication of an integrated device including a flash-EEPROM memory and transistors according to the present invention.

With reference to Fig.s 3-9, a description will first be given of the known DPCC process for fabricating EPROM cells and circuit transistors according to Patent US-A-4.719.184 mentioned above. In particular, the following description relates to various steps in a CMOS DPCC process for fabricating an EPROM memory cell and CMOS transistors.

Fig.3 shows an intermediate structure obtained by forming, in a P- type substrate 30, P type wells 31, N type wells 32, and P+ type enriched insulating regions 33 for the formation of channel stoppers, overlaid with thick field oxide regions 34. Over substrate 30, provision is also made for a gate oxide layer 35 covering the active regions (where the circuit transistors and memory array cell are to be formed) and which elsewhere merges with field oxide layer 34. All the above layers and regions are obtained through standard process steps.

An EPROM cell implant mask (EPM mask) is then formed for implanting boron ions in the channel area of the memory cell, as required for preventing punch-through of the substrate in the presence of strong electric fields, and for enhancing programming efficiency.

This step is shown in Fig.3, which shows the resist mask 36 covering the entire circuit portion (to the right in Fig.3 onwards, and indicated as a whole by 40a) and having a window 37 over the area in which the cell is to be formed (to the left in the drawings, and indicated 40b). Arrows 38 in Fig.3 indicate boron implantation for forming a P+ type layer 39 in the active region of the cell.

Resist mask 36 is then removed; a first polycrystalline silicon layer is deposited (poly1, indicated by 41 in Fig.4 onwards); and poly1 41 is doped with POCl₃ and subsequently shaped using a resist mask (42 in Fig.4) covering the entire circuit portion and which enables etching and removal of the exposed poly1 portions on either sides of memory area 40b, as shown in Fig.4.

A dielectric layer (so-called interpoly dielectric 43) is then grown consisting, in this case, of a triple ONO (thermal oxide/CVD nitride/thermal oxide) layer, but which may also consist of a single oxide layer as shown in Fig.5 (showing the intermediate structure after growing dielectric layer 43).

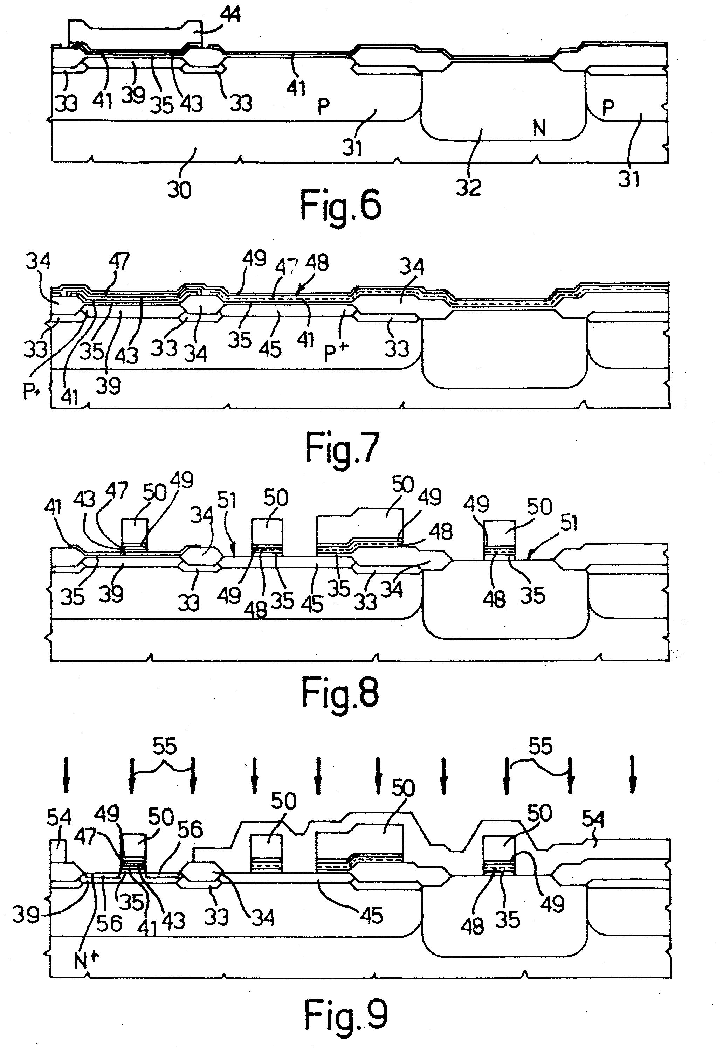

A mask (array mask 44, Fig.6) is then deposited to cover cell array area 40b and leave circuit area 40a exposed; the exposed portions of dielectric layer 43 are removed to give the intermediate structure shown in Fig.6; mask 44 is removed; a further mask (so-called LVS mask not shown in the drawings) is deposited; and boron ions are implanted to adjust the threshold of the N channel circuit transistors and so form a P+ enriched region 45 (Fig.7). At the same time, the above step also provides for reducing surface doping concentration in the active regions of the P channel transistors (in N well 32) and so adjusting the threshold to the desired value.

Following removal of the LVS mask (not shown), a second polycrystalline silicon layer (poly2 47) is deposited. As shown in Fig.7, in circuit area 40a, poly2 47 is deposited directly on to poly1 41 with which it merges to form a single polysilicon layer 48 (divided by the dotted line into two layers in the drawings for the sake of clarity), whereas, in the memory array area, it is separated from poly1 41 by dielectric layer 43. Poly2 47 is then doped with POCl₃, and a layer of CVD silicide 49, e.g. tungsten silicide WSi₂, is deposited to give the intermediate structure shown in Fig.7.

A mask 50 (poly2 mask, Fig.8) is then formed for shaping the gate regions of the circuit transistors and the control gate regions of the array cells; and the exposed portions of the polysilicon layer (41 for the memory cells and 48 for the transistors) are removed by etching down to polysilicon layer 41 of the memory cells and the larger surface 51 of the substrate in circuit transistor area 40a, to give the intermediate structure shown in Fig.8.

On top of the poly2 mask 50, a further mask (transistor protection mask 54, Fig.9) is deposited to cover only and all of circuit area 40a; and the portions of poly1 left exposed by mask 50 or 54 are etched (to self-align the floating gate regions with the control gate regions). Before removing mask 50, 54, arsenic is implanted, as shown by arrows 55 in Fig.9, so as to form, in the active area of the memory array cells and self-aligned with the floating gate and control gate regions, N type drain and source regions 56, as shown in the Fig.9 intermediate structure.

The rest of the process then follows the standard CMOS flow, for forming the source and drain regions of the circuit transistors, the component protection layers, and the connections.

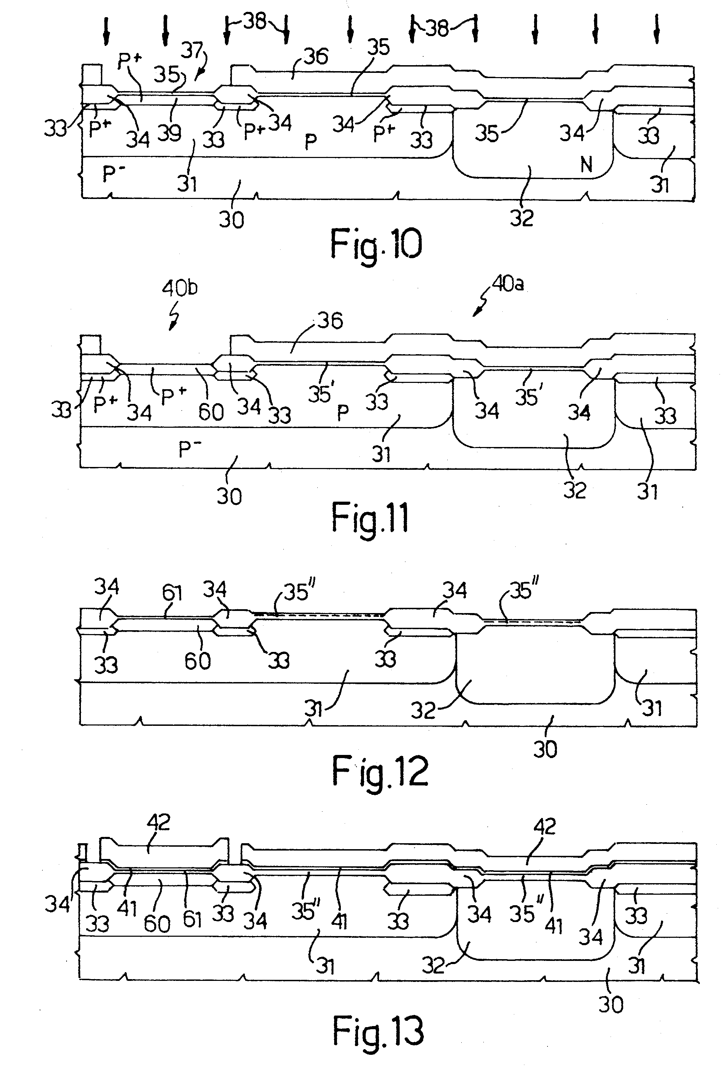

One embodiment of the process according to the present invention will now be described with reference to Figs. 10-13 and relative to the formation of a flash-EEPROM cell and a pair of CMOS complementary transistors.

The process according to the present invention comprises the same initial steps described above for forming the intermediate structure in Fig.3, which is again reproduced in Fig.10 for the sake of clarity. Any layers or regions in the present process identical to those of the known process described above are indicated using the same numbering system as in Figs. 3-9.

Fig.10 shows a P- type substrate 30 housing P type wells 31 and N type wells 32; field insulating regions 34; channel stoppers 33; and a thin oxide layer 35'. As explained in more detail later on, for obtaining the required finish thickness of layer 35', a number of parameters must be adjusted as compared with the known process described with reference to Figs. 3-9. In Fig.10, the cell implant (EPM) mask 36 is already present, and, as in Fig.3, a cell implant (arrows 38') is performed for obtaining P type regions 60. In view of the different characteristics of the EPROM cells formed in the Fig.3-9 process and the flash-EEPROM cells being produced here, the conditions of implant 38' differ from those of the EPROM process as per se known.

Using the same cell implant (EPM) mask 36, gate oxide layer 35' is etched and removed from the cell region to give the intermediate structure shown in Fig.11, at which point, EPM mask 36 is removed and the wafer cleaned. The wafer is then oxidized to grow a thin oxide layer 61 directly on the surface of the substrate in the cell area, the oxidation parameters being so selected as to achieve the required characteristics, and particularly thickness, of the thin tunnel oxide layer. Oxidation also results in a slight increase in thickness of the gate oxide of the circuit transistors, as shown (exaggeratedly for the sake of clarity) by the dotted line in Fig.12 showing the original thickness of layer 35'. The gate oxide layer on the circuit portion is now indicated 35'' to take into account the increase in thickness, though it is substantially equivalent to layer 35 in the known process.

As stated above, the initial thickness of gate oxide layer 35' must therefore be so calculated as to allow for the tunnel oxidation increase and the slight reduction when cleaning the wafer (prior to forming the thin tunnel oxide).

At this point, the known process flow is followed for depositing a first polycrystalline silicon layer 41; doping it with POCl₃; forming poly1 mask 42; and shaping layer 41, as shown in Fig.13, and exactly as shown in Fig.4 except for thin oxide layer 61 and the different characteristics of region 60. This is followed by the steps shown in Figs. 5-9 relative to the known process, and which include depositing a dielectric layer; removing it from the circuit portion; depositing a second polysilicon layer; depositing a silicide layer; shaping the gate regions in the circuit transistor area and the control gate regions in the array; self-aligned shaping of the floating gate regions in the array; source and gate implants of the array cells and circuit transistors; and formation of the protection and connecting layers.

The process according to the present invention thus provides for producing a flash-EEPROM memory array and associated transistors using the DPCC process, and so exploiting the intrinsic advantages, and in particular the experience and know-how, of the process for obtaining memories of known, reliable electric characteristics. Moreover, the possibility of producing flash-EEPROM memories using the DPCC process provides for producing two families of products (EPROM and flash-EEPROM memories) on the same fabrication line, with no significant differences and using the same machinery.

The specific solution described also provides for producing flash-EEPROM memory cells with no need for specific masking and therefore at substantially the same cost as EPROM memories.

To those skilled in the art it will be clear that changes may be made to the process as described and illustrated herein. In particular, the process described is applicable to devices including CMOS and NMOS transistors, regardless of the type of dielectric employed (ONO or single oxide layer), and regardless of the material of the control gate region (polysilicon or polycide, i.e. polysilicon and silicide).

## Claims

1. A process of fabricating flash-EEPROM nonvolatile memory cells and circuit transistors from a substrate having a main surface (51) and defining cell areas (40b) in which to form the memory cells, and transistor areas (40a) in which to form the circuit transistors comprising, in combination, the steps of:
- growing field oxide regions (34) on predetermined portions of said main surface (51) of said substrate (30);
- forming a gate oxide layer (35') on said main surface of said substrate, in said transistor areas (40a);
- forming a tunnel oxide layer (61) on said main surface of said substrate, in said cell areas (40b) said tunnel oxide layer (61) being thinner than said gate oxide layer (35');
- depositing a first polycrystalline silicon layer (41);
- selectively removing portions of said first polycrystalline silicon layer (41) at the sides of said cell areas (40b) and said transistor areas (40a);
- depositing a dielectric material layer (43);
- removing said dielectric material layer (43) in said transistor areas (40a);
- depositing a second polycrystalline silicon layer (47);
- forming a mask (50) and selectively removing said second polycrystalline silicon layer (47) and said underlying dielectric layer (43) at the sides of said cell areas (40b), and said second and first polycrystalline silicon layers (47, 41) and said gate oxide layer (35) at the sides of said transistor areas (40a), so as to leave the source and drain forming areas of said circuit transistors exposed; and
- using said mask (50), selectively removing said first polycrystalline silicon layer (41) and said thin tunnel oxide layer (61) at the sides of said cell areas (40b), so as to leave the source and drain forming areas of the cells exposed.

2. A process as claimed in Claim 1, further characterized by the fact that said step of forming a thin tunnel oxide layer (61) is performed after said step of forming a gate oxide layer (35').

3. A process as claimed in Claim 2, further characterized by the fact that said step of forming a gate oxide layer comprises the steps of growing a gate oxide layer (35') over the whole of said main surface of said substrate (30) and selectively removing said gate oxide layer from said cell areas (40b).

4. A process as claimed in Claim 3, further characterized by the fact that, following said step of growing a gate oxide layer (35') over the whole of said main surface of said substrate (30), and prior to said step of forming a thin tunnel oxide layer (61), there are performed the steps of: forming a doping mask (36) covering said transistor areas (40a) and exposing said cell areas (40b); doping (38) said cell areas (40b) with conductivity-modifying ions and using said doping mask (36); and by the fact that said step of selectively removing said gate oxide layer (35') from said cell areas (40b) is performed using said doping mask (36).

5. A process as claimed in Claim 4, further characterized by the fact that said step of doping (38) said cell area (40b) is performed through said gate oxide layer (35').

6. A process as claimed in Claim 4 or 5, further characterized by the fact that said doping mask (36) is removed following said step of selectively removing said gate oxide layer (35') from said cell area (40b); and by the fact that said step of forming a thin tunnel oxide layer (61) is performed over the whole surface of said substrate (30), so as to increase the thickness of said gate oxide layer (35") in said transistor areas (40a).

## Patentansprüche

1. Ein Verfahren zur Herstellung von nichtflüchtigen Flasch-EEPROM Speicherzellen und Schaltungstransistoren aus einem Substrat, das eine Hauptoberfläche (51) aufweist und Zellenbereiche (40b) festlegt, in denen die Speicherzellen zu bilden sind, und Transistorbereiche (40a), in denen die Schaltungstransistoren zu bilden sind; **gekennzeichnet** durch die Tatsache, daß es in Kombination die Schritte umfaßt:
- Aufwachsen von Feldoxidbereichen (34) auf vorbestimmten Bereichen der genannten Hauptoberfläche (51) des genannten Substrats (30);
- Bilden einer Gateoxidschicht (35') auf der genannten Hauptoberfläche des genannten Substrats in den genannten Transistorbereichen (40a);
- Bilden einer Tunneloxidschicht.(61) auf der genannten Hauptoberfläche des genannten Substrats in den genannten Zellenbereichen (40b), wobei die genannte Tunneloxidschicht (61) dünner als die genannte Gateoxidschicht (35') ist;
- Abscheiden einer ersten, polykristallinen Siliciumschicht (41);
- selektives Entfernen von Bereichen der genannten erste, polykristallinen Siliciumschicht (41) auf den Seiten der genannten Zellenbereiche (40b) und der genannten Transistorbereiche (40a) ;
- Abscheiden einer dielektrischen Materialschicht (43);
- Entfernern der genannten dielektrischen Materialschicht (43) in den genannten Transistorbereichen (40a);
- Abscheiden einer zweiten, polykristallinen Siliciumschicht (47);
- Bilden einer Maske (50) und selektives Entfernen der genannten zweiten, polykristallinen Siliciumschicht (47) und der genannten darunterliegenden, dielektrischen Schicht (43) auf den Seiten der genannten Zellenbereiche (40b) und der genannten zweiten und ersten, polykristallinen Siliciumschichten (47, 41) und der genannten Gateoxidschicht 35 auf den Seiten der genannten Transistorbereiche (40a), damit die die Source und die Drain bildende Bereiche der genannten Schaltungstransistoren freigelegt sind; und
- Verwenden der genannten Maske (50) zum selektiven Entfernen der genannten ersten, polykristallinen Siliciumschicht (41) und der genannten dünnen Tunneloxidschicht (61) auf den Seiten der genannten Zellenbereiche (40b), damit die die Source und Drain bildenden Bereiche der Zellen freigelegt sind.

2. Ein Verfahren, wie in Anspruch 1 beansprucht, des weiteren **gekennzeichnet** durch die Tatsache, daß der genannte Schritt des Bildens einer dünnen Tunneloxidschicht (61) nach dem genannten Schritt des Bildens einer Gateoxidschicht (35') ausgeführt wird.

3. Ein Verfahren, wie in Anspruch 2 beansprucht, des weiteren **gekennzeichnet** durch die Tatsache, daß der genannte Schritt des Bildens einer Gateoxidschicht die Schritte umfaßt, eine Gateoxidschicht (35') über dem Ganzen der genannten Hauptoberfläche des genannten Substrats (30) aufzuwachsen und selektiv die genannte Gateoxidschicht von den genannten Zellenbereichen (40b) zu entfernen.

4. Ein verfahren, wie in Anspruch 3 beansprucht, des weiteren **gekennzeichnet** durch die Tatsache, daß nach dem genannten Schritt des Aufwachsens einer Gateoxidschicht (35') über dem Ganzen der genannten Hauptoberfläche des genannten Substrats (30) und vor dem genannten Schritt des Bildens einer dünnen Tunneloxidschicht (61) die Schritte ausgeführt werden: Bilden einer Dotierungsmaske (36), die die genannten Transistorbereiche (40a) überdeckt, und Freilegen der genannten Zellenbereiche (40b) ; Dotieren (38) der genannten Zellenbereiche (40b) mit die Leitfähigkeit ändernden Ionen unter verwendung der genannten Dotierungsmaske (36); und durch die Tatsache, daß der genannte Schritt des selektiven Entfernens der genannten Gateoxidschicht (35') von den genannten Zellenbereichen (40b) unter Verwendung der genannten Dotierungsmaske (36) ausgeführt wird.

5. Ein Verfahren, wie in Anspruch 4 beansprucht, des weiteren **gekennzeichnet** durch die Tatsache, daß der genannte Schritt des Dotierens (38) des genannten Zellenbereiches (40b) durch die genannte Gateoxidschicht (35') hindurch ausgeführt wird.

6. Ein Verfahren, wie in Anspruch 4 oder 5 beansprucht, des weiteren **gekennzeichnet** durch die Tatsache, daß die genannte Dotierungsmaske (36) nach dem genannten Schritt des selektiven Entfernens der genannten Gateoxidschicht (35') von den genannten Zellenbereichen (40b) entfernt wird; und durch die Tatsache, daß der genannte Schritt des Bildens einer dünnen Tunneloxidschicht (61) über der gesamten oberfläche des genannten Substrats (30) ausgeführt wird, damit die Dicke der genannten Gateoxidschicht (35") in den genannten Transistorbereichen (40a) erhöht wird.

## Revendications

1. Procédé de fabrication de cellules de mémoire non volatiles EEPROM rapides et de transistors de circuit à partir d'un substrat présentant une surface principale (51) et définissant des zones de cellules (40b) dans lesquelles sont formées les cellules de mémoire, et des zones de transistors (40a) dans lesquelles sont formés les transistors de circuit; caractérisé en ce qu'il comprend, de manière combinée, les étapes de:
croissance de zones d'oxyde de champ (34) sur des parties prédéterminées de ladite surface principale (51) dudit substrat (30);
formation d'une couche d'oxyde de grille (35') sur ladite surface principale dudit substrat, dans lesdites zones de transistors (40a);
formation d'une couche d'oxyde de tunnel (61) sur ladite surface principale dudit substrat, dans lesdites zones de cellules (40b), ladite couche d'oxyde de tunnel (61) étant plus mince que ladite couche d'oxyde de grille (35');
dépôt d'une première couche de silicium polycristallin (41);
élimination sélective de parties de ladite première couche de silicium polycristallin (41) sur les côtés desdites zones de cellules (40b) et desdites zones de transistors (40a);
dépôt d'une couche de matériau diélectrique (43);
élimination de ladite couche de matériau diélectrique (43) dans lesdites zones de transistors (40a);
dépôt d'une seconde couche de silicium polycristallin (47);
formation d'un masque (50) et élimination sélective de ladite seconde couche de silicium polycristallin (47) et de ladite couche diélectrique sous-jacente (43) sur les côtés desdites zones de cellules (40b), et desdites seconde et première couches de silicium polycristallin (47, 41) et de ladite couche d'oxydé de grille (35) sur les côtés desdites zones de transistors (40a), de manière à laisser apparentes les zones de formation des source et drain desdits transistors de circuit; et
en utilisant ledit masque (50), d'élimination sélective de ladite première couche de silicium polycristallin (41) et de ladite couche mince d'oxyde de tunnel (61) sur les côtés desdites zones de cellules (40b), de manière à laisser apparentes les zones de formation de source et drain des cellules.

2. Procédé selon la revendication 1, caractérisé, en outre, en ce que ladite étape de formation d'une couche mince d'oxyde de tunnel (61) est réalisée après ladite étape de formation d'une couche d'oxyde de grille (35').

3. Procédé selon la revendication 2, caractérisé, en outre, en ce que ladite étape de formation d'une couche d'oxyde de grille comprend les étapes de croissance d'une couche d'oxyde de grille (35') sur la totalité de ladite surface principale dudit substrat (30) et d'élimination sélective de ladite couche d'oxyde de grille présente sur lesdites zones de cellules (40b).

4. Procédé selon la revendication 3, caractérisé, en outre, en ce que, à la suite de ladite étape de croissance d'une couche d'oxyde de grille (35) sur la totalité de ladite surface principale dudit substrat (30), et avant ladite étape de formation d'une couche mince d'oxyde de tunnel (61), les étapes suivantes sont réalisées: formation d'un masque de dopage (36) recouvrant lesdites zones de transistors (40a) et exposition desdites zones de cellules (40b); dopage (38) desdites zones de cellules (40b) par des ions modifiant la conductivité en utilisant ledit masque de dopage (36); et en ce que ladite étape d'élimination sélective de ladite couche d'oxyde de grille (35') présente sur lesdites zones de cellules (40b) est réalisée en utilisant ledit masque de dopage (36).

5. Procédé selon la revendication 4, caractérisé, en outre, en ce que ladite étape de dopage (38) de ladite zone de cellules (40b) est réalisée à travers ladite couche d'oxyde de grille (35').

6. Procédé selon la revendication 4 ou 5, caractérisé, en outre, en ce que ledit masque de dopage (36) est éliminé à la suite de ladite étape d'élimination sélective de ladite couche d'oxyde de grille (35') présente sur ladite zone de cellules (40b); et en ce que ladite étape de formation d'une couche mince d'oxyde de tunnel (61) est réalisée sur la totalité de la surface dudit substrat (30), de manière à augmenter l'épaisseur de ladite couche d'oxyde de grille (35") dans lesdites zones de transistors (40a).
